# EUROPÄISCHE PATENTSCHRIFT

(11) **EP 1 487 605 B1**
(45) Veröffentlichungstag und Bekanntmachung des Hinweises auf die Patenterteilung: **19.12.2007**
(21) Anmeldenummer: 03711841.1
(22) Anmeldetag: 12.03.2003
(51) Int. Cl.: B23K 26/06, B23K 26/08, G03F 7/00

(54) **VORRICHTUNG UND VERFAHREN ZUR LASERSTRUKTURIERUNG VON FUNKTIONSPOLYMEREN UND VERWENDUNGEN**
DEVICE AND METHOD FOR LASER STRUCTURING FUNCTIONAL POLYMERS AND THE USES THEREOF
DISPOSITIF ET PROCEDE POUR LA STRUCTURATION PAR LASER DE POLYMERES FONCTIONNELS ET UTILISATIONS ASSOCIEES

(30) Priorität: 21.03.2002 DE 10212639
(43) Veröffentlichungstag der Anmeldung: 22.12.2004
(73) Patentinhaber: PolyIC GmbH & Co. KG, 90763 Fürth (DE)
(72) Erfinder: BERNDS, Adolf, 91083 Baiersdorf (DE); CLEMENS, Wolfgang, 90617 Puschendorf (DE); ROTH, Hans-Klaus, 07330 Laasen (DE); SCHRÖDNER, Mario, 07407 Rudolstadt (DE); STOHN, Ralf-Ingo, 07749 Jena (DE)
(74) Vertreter: Zinsinger, Norbert
(86) Internationale Anmeldenummer: PCT/DE2003/000791
(87) Internationale Veröffentlichungsnummer: WO 2003/080285

(56) Entgegenhaltungen:
- EP-A- 1 224 999
- US-A- 5 486 851

## Beschreibung

Die Erfindung betrifft eine Vorrichtung und ein Verfahren zur Laserstrukturierung und Verwendungen in der Halbleiterproduktion dazu.

Zur Strukturierung von organischen Funktionspolymeren sind im Wesentlichen zwei Methoden bekannt, die Photolithographie, die eine Stück-für-Stück Abarbeitung erfordert und kontinuierliche Druckmethoden.

Aus der DE 100 33 112, der DE 100 43 204 und der DE 100 61 297 sind kontinuierliche Druckverfahren zur Strukturierung von organischen Funktionspolymeren bekannt, Mit diesen schnellen Druckverfahren kann jedoch noch nicht das hohe Auflösungsvermögen, das durch photolithographische Strukturierungsmethoden erreicht wird, erzielt werden.

Aus der US 5,652,645 ist ein System zur Bildprojektion bekannt, das die Bearbeitung großer Substrate im kontinuierlichen Verfahren erlaubt. Die Beleuchtung erfolgt über einen hexagonalen Beleuchtungsstrahl durch eine Maske. Mit dieser Beleuchtung können jedoch keine Strukturen erzeugt werden.

Aus der US 5,967,048 ist ein Verfahren zur Bilderzeugung bekannt, das mittels Laserstrahlen ein Bild auf einem sich bewegenden Band erzeugt. Hier werden keine Strukturen ausgebildet, sondern das Verfahren dient zur Bilderzeugung.

Deshalb ist es Aufgabe der Erfindung, ein Verfahren zur kontinuierlichen Strukturierung von Funktionspolymeren zu schaffen, bei dem trotz hoher Durchlaufgeschwindigkeit des Funktionspolymers eine hohe Auflösung der Strukturierung realisiert werden kann.

Gegenstand der Erfindung ist eine Vorrichtung zur Strukturierung eines Funktionspolymers, zumindest ein kontinuierlich sich bewegendes Band mit einem Schichtträger, zumindest einen Laser und zumindest eine Maske zwischen dem Laser und dem Schichtträger umfassend, wobei Laser, Maske und Schichtträger so angeordnet sind, dass der beschichtete Träger auf dem während des Belichtungsprozesses sich kontinuierlich bewegenden Band durch die Maske mittels Laser so beschossen wird, dass die Schicht auf dem Träger der Maske entsprechend lokal entfernt wird. Außerdem ist Gegenstand der Erfindung ein Verfahren zur Strukturierung von Funktionspolymeren durch zumindest eine Laserablation, bei dem in einem kontinuierlichen Arbeitsprozess auf zumindest einem durchlaufenden Schichtträger, der zumindest mit einem Funktionspolymer beschichtet ist, das Bild einer Maske durch zumindest einen Laserpuls so projiziert wird, dass das Funktionspolymer der Maske entsprechend lokal entfernt wird. Schließlich sind Gegenstand der Erfindung mehrere Verwendungen des Verfahrens zur Herstellung von integrierten Schaltungen.

Als Funktionspolymer wird ein organisches Material verstanden, das im Halbleiterbauelement eine Funktion (leitend, nicht leitend, halbleitend, lichtdurchlässig, lichtdicht und/oder isolierend) oder eine Kombination mehrerer Funktionen erfüllt.

Der Begriff "organisches Material" oder "Funktionspolymer" oder "Polymer" umfasst hier alle Arten von organischen, metallorganischen und/oder organisch-anorganischen Kunststoffen (Hybride), insbesondere die, die im Englischen z.B. mit "plastics" bezeichnet werden. Es handelt sich um alle Arten von Stoffen mit Ausnahme der Halbleiter, die die klassischen Dioden bilden (Germanium, Silizium), und der typischen metallischen Leiter. Eine Beschränkung im dogmatischen Sinn auf organisches Material als Kohlenstoff-enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich. Der Wortbestandteil "polymer" im Funktionspolymer ist historisch bedingt und enthält insofern keine Aussage über das Vorliegen einer tatsächlich polymeren Verbindung.

Die Laserablation als Methode zur Erzeugung von strukturierten Funktionspolymerschichten ist eine Direktlithographie, bei der durch Laserbeschuss sowohl der Effekt der strukturierten Belichtung als auch der trockene Ätzprozess des herkömmlichen photolithographischen Prozesses zusammengefasst werden. Laserstrukturierung ist bislang nur im Zusammenhang mit der Stück-für-Stück Verarbeitung in der Halbleiterproduktion bekannt. Nach der Erfindung wird analog zur Photolithographie das Bild einer Maske simultan auf die zu strukturierende Schicht projiziert.

Mit der Erfindung wird erstmals die Laserablation, also die lokale Entfernung von Polymermaterial durch Laserbeschuss in einen kontinuierlichen Prozess der Halbleiterproduktion eingeführt.

Vorteilhafterweise wird als kontinuierlicher Prozess ein Rolle zu Rolle Verfahren eingesetzt, wobei ein Band mit einem Schichtträger (Substratrolle) mit hoher Geschwindigkeit Arbeitsschritte wie Bedrucken, Beschichten etc. durchläuft, ohne für den Ablationsprozess angehalten werden zu müssen.

Nach einer vorteilhaften Ausgestaltung erfolgt die Laserablation durch einen einzelnen Laserpuls.

Ein einzelner Laserpuls ist mit etwa 20 ns so kurz, dass er selbst auf einem mit höchster Geschwindigkeit, z.B. 20 m/s, durchlaufendem Band scharfe Bilder erzeugt. In dem Zahlenbeispiel beträgt die durch die Bewegung des Bandes entstehende Unschärfe weniger als 1 nm. Das ist gegenüber den angestrebten Strukturgrößen im Mikrometerbereich vernachlässigbar.

Damit ist klar, dass die Laserstrukturierung prinzipiell kompatibel mit Rolle-zu-Rolle Prozessen ist. Zur Klarstellung soll erwähnt werden, dass es sich hier nicht um das häufig verwendete sequentielle Schreiben mit einem fokussierten Laserstrahl handelt, was bezüglich Geschwindigkeit und Auflösungsvermögen an Grenzen stößt, sondern um Laserpulsen, das heißt es wird analog zur Photolithographie das Bild einer Maske simultan auf die zu strukturierende Schicht projiziert, so dass jeder Laserpuls eine komplette integrierte Schaltung erzeugt.

Nach einer Ausgestaltung wird die Maske um den Faktor 5 verkleinert abgebildet. Anders ausgedrückt ist die Maske typischerweise 5mal größer als ihre Projektion, um die Leistungsdichte in der Maske zu verkleinern, da sonst die Maske selbst abladiert würde.

Nach einer Ausgestaltung ist die Laserablation mit zumindest einer Vorrichtung zum Absaugen kombiniert.

Das Verfahren kann alle Prozessschritte der Stereolithographie in der Halbleiterproduktion ersetzten. Insbesondere kann das Verfahren angewendet werden auf:
- die Laserstrukturierung von Elektroden (Source/Drain und Gate) in organischen Feld Effekt Transistoren.
   Diese Elektroden können Metalle (z.B. Gold, Aluminium, Kupfer) oder leitfähige Polymere (z.B. Polyanilin und PEDOT/PSS, Polypyrrol, Polyacetylen,....) oder sonstige leitfähige, insbesondere organische, Materialien oder Verbundmaterialien (z.B. leitfähige Russe, Pasten mit Metallanteilen (z.B. Leitsilber)) umfassen. Beispielsweise sind folgende leitfähige Polymere mit Laser strukturierbar: Polyanilin (PANI); Poly(3,4-ethylendioxythiophen (PEDOT); Polypyrrol (Ppy).
   Für Source/Drain-Elektroden konnten Strukturgrößen bis hinunter zu 1 µm erreicht werden. Auch Ablationsversuche in Mehrschichtaufbauten wurden schon vorgenommen.
   Dabei kommt es darauf an nur die oberste Schicht abzutragen ohne die darunterliegende anzugreifen. Das kann man erreichen, durch Einstellung der Energie bzw. Leistung eines Laserpulses, der Wellenlänge des Laserlichts und der Anzahl der Laserpulse. Das spielt eine Rolle bei der Strukturierung der Gate-Elektrode, die im Transistoraufbau die oberste Schicht bildet.
- Die Strukturierung von Halbleiter - und/oder Isolatorschichten. Beispiele für organische Halbleiter sind: Polythiophene, Polyfluorene, Pentacen, Perylen....; Ein Beispiel für einen organischen Isolator ist Poly-4-venylphenol oder Polyhydroxystyrol.
- Durchkontaktierungen (Vias) in organischen Transistoren: Im Transistor sind die Elektroden (Source/Drain und Gate) durch die zwischenliegende Halbleiter- und Isolatorschicht voneinander getrennt. Eine Verbindung zwischen den beiden, wie sie zur Herstellung von integrierten Schaltkreisen erforderlich ist, könnte ebenfalls durch Laserstrukturierung geschehen, d.h. durch lokale punktgenaue Entfernung der Halbleiter- und Isolatorschicht und anschließender Auffüllung des Loches mit einem leitfähigen Material.
- Weitere Anwendungen des Verfahrens zur Herstellung organischer Schaltungen sind:
   Leiterbahnen, Kontaktpads und Widerstände, Elektroden, Halbleiterschichten, Isolatorschichten für andere elektronische organische Bauteile, z.B. für Kondensatoren, organische Diodenstrukturen oder organische Photovoltaikstrukturen.

Im Folgenden wird die Erfindung noch anhand einer Figur erläutert:

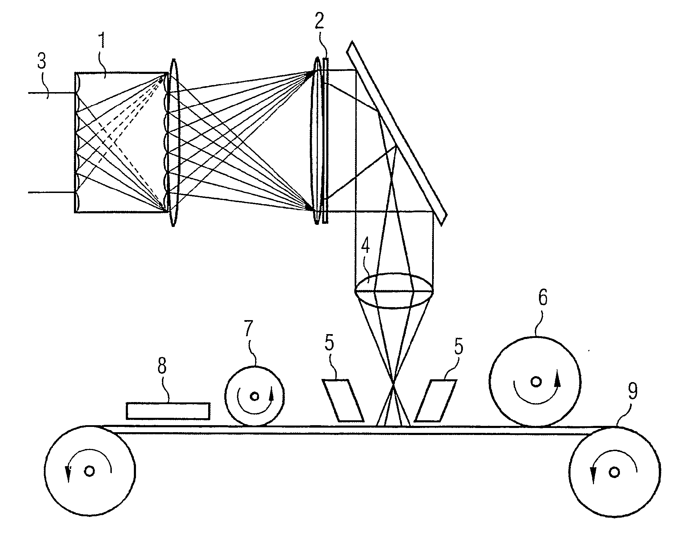

Die Figur zeigt ein Ausführungsbeispiel einer Anordnung zur Laserstrukturierung von Funktionspolymeren im Rolle-zu-Rolle Verfahren in Kombination mit anderen Vorrichtungen zur Schichterzeugung und -behandlung.

Zu erkennen ist ein Laser 1 mit Optik. Bevorzugt werden Laser eingesetzt, die im ultravioletten Spektralbereich emittieren (ca. 100 bis 350 nm). Typischerweise handelt es sich um Excimer-Laser. Die Optik dient dazu, den Laserstrahl aufzuweiten. Der Laserstrahl 3 dringt dann durch die Maske 2. Die Abbildung einer Maske 2 im Strahlengang 3 sorgt dafür, dass nicht die komplette Funktionspolymerschicht, sondern gezielte Bereiche daraus entfernt werden, so dass genau die gewünschte Form der Elektroden oder Leiterbahnen übrig bleibt. Der Laserstrahl hat bevorzugt an der Maske einen größeren Querschnitt, damit die Maske vor Beschädigung geschützt ist. Deshalb ist die Optik 4 erforderlich, die die Maske verkleinert auf die Funktionspolymerschicht abbildet.

Die Optik 4 lenkt den Strahl auf die zu strukturierende Substratrolle 9, z.B. einen Schichtträger. Nun wird durch Einwirkung des Laserstrahls 3 ein Teil einer Funktionspolymerschicht, die sich auf der Substratrolle 9 befindet, lokal entfernt. Das auf der Substratrolle 9 verbleibende Funktionspolymer bildet dann z.B. Elektroden und/oder Leiterbahnen etc., wenn es sich bei dem Funktionspolymer um ein leitfähiges Funktionspolymer handelt. Das Funktionspolymer wird wie in einem trockenem Ätzprozess entfernt. Die skizzierte Anlage enthält eine Absaugvorrichtung 5, da damit zu rechnen ist, dass durch die Laserablation Abbauprodukte entstehen.

Weiterhin sind in Rollrichtung vor und nach der Laserablation Vorrichtungen zur Schichterzeugung 6 und Schichtbehandlung und/oder Bedruckung 7 vorgesehen. So kann z.B. die Vorrichtung 6 eine Beschichtungsanlage sein, die eine vollständige Schicht erzeugt, die anschließend laserstrukturiert wird. Die Vorrichtung 7 kann z.B. ein Druckwerk sein, dass durch Drucktechniken eine weitere strukturierte Schicht aufbringt. Danach ist es unter Umständen erforderlich, die gedruckte Schicht zu trocknen, dazu wird eine Trocknungsanlage 8 vorgeschlagen.

Das gezeigte Ausführungsbeispiel kann beliebig verändert und erweitert werden, insbesondere sind mehrere hintereinander und/oder parallel geschaltete Laserstrukturierungsschritte denkbar. So könnte ein erster Laser die Elektrodenstrukturierung durchführen und nach weiterer Schichtauftragung ein weiterer Laser die Durchkontaktierung (VIAS).

Die Laserstrukturierung kombiniert zwei Vorteile miteinander. Erstens ist sie, wie oben gezeigt, Rolle-zu-Rolle kompatibel und erlaubt damit höchste Produktionsgeschwindigkeiten. Zweitens verfügt sie über ein sehr hohes Auflösungsvermögen. Zur Zeit existiert kein anderes Verfahren zur Halbleiterstrukturierung, dass diese beiden Vorteile in sich vereint, weder die Photolithographie noch Druckprozesse oder andere Methoden. Weiterhin ist die Laserstrukturierung kombinierbar mit anderen Rolle-zu-Rolle Prozessen wie das Drucken.

## Patentansprüche

1. Vorrichtung zur Strukturierung eines Funktionspolymers, zumindest ein kontinuierlich sich bewegendes Band mit einem Schichtträger, zumindest einen Laser und zumindest eine Maske zwischen dem Laser und dem Schichtträger umfassend, wobei Laser, Maske und Schichtträger so angeordnet sind, dass der mit dem Funktionspolymer beschichtete Träger auf dem während des Belichtungsprozesses sich kontinuierlich bewegenden Band durch die Maske mittels Laser so beschossen wird, dass eine Schicht des Funktionspolymers auf dem Träger der Maske entsprechend lokal entfernt wird.

2. Vorrichtung nach Anspruch 1, bei der der Laser im ultravioletten Spektralbereich emittiert.

3. Vorrichtung nach einem der vorstehenden Ansprüche, bei der der Laser ein Excimer Laser ist.

4. Vorrichtung nach einem der vorstehenden Ansprüche, die eine Vorrichtung zum Absaugen umfasst.

5. Verfahren zur Strukturierung von Funktionspolymeren durch zumindest eine Laserablation, bei dem in einem kontinuierlichen Arbeitsprozess auf einen durchlaufenden Schichtträger, der zumindest mit einem Funktionspolymer beschichtet ist, das Bild einer Maske durch zumindest einen Laserpuls so projiziert wird, dass das Funktionspolymer der Maske entsprechend lokal entfernt wird.

6. Verfahren nach Anspruch 5, bei dem der kontinuierliche Arbeitsprozess ein Rolle zu Rolle Verfahren ist.

7. Verfahren nach einem der Ansprüche 5 oder 6, bei dem die Laserablation durch einen einzelnen Laserpuls erfolgt.

8. Verfahren nach einem der vorstehenden Ansprüche 5 bis 7, bei dem die Maske um den Faktor 5 verkleinert projiziert wird.

9. Verwendung der Vorrichtung nach einem der Ansprüche 1 bis 4 und/oder des Verfahrens nach einem der Ansprüche 5 bis 8 zur Laserstrukturierung von Elektroden, zur Laser Strukturierung von Halbleiter - und/oder Isolatorschichten, zu Durchkontaktierungen (Vias) von organischen Transistoren und/oder zur Herstellung von Leiterbahnen, Kontaktpads, Widerständen, Elektroden, Halbleiterschichten, Isolatorschichten für elektronische und/oder elektrische Bauteile, für Kondensatoren, organische Diodenstrukturen oder organische Photovoltaikstrukturen

## Claims

1. Device for patterning a functional polymer, comprising at least one continuously moving strip with a layer carrier, at least one laser and at least one mask between the laser and the layer carrier, wherein laser, mask and layer carrier are arranged in such a way that the carrier coated with the functional polymer on the strip, moving continuously during the exposure process, is bombarded through the mask by means of the laser in such a way that a layer of the functional polymer on the carrier is locally removed in accordance with the mask.

2. Device according to Claim 1, in which the laser emits in the ultraviolet spectral range.

3. Device according to one of the preceding claims, in which the laser is an excimer laser.

4. Device according to one of the preceding claims, which comprises a device for removal by suction.

5. Method for patterning functional polymers by means of at least one laser ablation, in which, in a continuous work process, the image of a mask is projected onto a continuous layer carrier, which is coated at least with a functional polymer, by means of at least one laser pulse in such a way that the functional polymer is removed locally in accordance with the mask.

6. Method according to Claim 5, in which the continuous work process is a roll to roll method.

7. Method according to either of Claims 5 and 6, in which the laser ablation is effected by means of an individual laser pulse.

8. Method according to one of the preceding Claims 5 to 7, in which the mask is projected in a manner demagnified by the factor 5.

9. Use of the device according to one of Claims 1 to 4 and/or the method according to one of Claims 5 to 8 for the laser patterning of electrodes, for the laser patterning of semiconductor and/or insulator layers, for plated-through holes (vias) of organic transistors and/or for producing interconnects, contact pads, resistors, electrodes, semiconductor layers, insulator layers for electronic and/or electrical components, for capacitors, organic diode structures or organic photovoltaic structures.

## Revendications

1. Dispositif pour la structuration d'un polymère de fonction, comprenant au moins une bande se déplaçant de façon continue avec un support de couche, au moins un laser et au moins un masque entre le laser et le support de couche, le laser, le masque et le support de couche étant disposés de telle sorte que le support revêtu est bombardé sur la bande se déplaçant de façon continue avec le corps de fonction pendant le processus d'éclairage par le masque au moyen de laser de telle sorte qu'une couche du polymère de fonction est enlevée localement de façon appropriée sur le support du masque.

2. Dispositif selon la revendication 1, sur lequel le laser émet dans la plage spectrale ultraviolette.

3. Dispositif selon l'une quelconque des revendications précédentes, sur lequel le laser est un laser à excimères.

4. Dispositif selon l'une quelconque des revendications précédentes, qui comprend un dispositif pour l'aspiration.

5. Procédé pour la structuration de polymères de fonction par au moins une ablation au laser, dans lequel, dans un processus de travail continu et sur un support de couche continu, qui est revêtu d'au moins un polymère de fonction, l'image d'un masque est projetée par au moins une impulsion laser de telle sorte que le polymère de fonction du masque est enlevé localement de façon appropriée.

6. Procédé selon la revendication 5, dans lequel le processus de travail continu est un procédé de rouleau à rouleau.

7. Procédé selon l'une quelconque des revendications 5 ou 6, dans lequel l'ablation au laser s'effectue par une impulsion laser individuelle.

8. Procédé selon l'une quelconque des revendications 5 à 7 précédentes, dans lequel le masque est projeté avec une réduction du facteur 5.

9. Utilisation du dispositif selon l'une quelconque des revendications 1 à 4 et/ou du procédé selon l'une quelconque des revendications 5 à 8 pour la structuration au laser d'électrodes, pour la structuration au laser de semiconducteur - et/ou de couches isolantes, pour des connexions transversales (Vias) de transistors organiques et/ou pour la fabrication de pistes conductrices, de pastilles (pads) de contact, de résistances, d'électrodes, de couches à semi-conducteurs, de couches isolantes pour des composants électroniques et/ou électriques, pour des condensateurs, des structures de diodes organiques ou des structures photovoltaïques organiques.
